# FASCICULE DE BREVET EUROPEEN

(11) **EP 3 390 682 B1**
(45) Date de publication et mention de la délivrance du brevet: **30.10.2019**
(21) Numéro de dépôt: 16825538.8
(22) Date de dépôt: 16.12.2016
(51) Int. Cl.: C03C 17/34, C09D 183/04, C23C 14/10, C23C 14/12, C23C 14/06, C03C 17/00, G02B 1/111, G02B 1/115, C23C 14/24

(54) **ARTICLE COMPRENANT UNE COUCHE ORGANIQUE-INORGANIQUE DE BAS INDICE DE RÉFRACTION**
ARTIKEL MIT EINER ORGANISCH-ANORGANISCHEN SCHICHT MIT NIEDRIGEM BRECHUNGSINDEX
ITEM COMPRISING AN ORGANIC-INORGANIC LAYER WITH A LOW REFRACTIVE INDEX

(30) Priorité: 18.12.2015 FR 1562857
(43) Date de publication de la demande: 24.10.2018
(73) Titulaire: Essilor International (Compagnie Générale d'Optique), 94220 Charenton-le-Pont (FR); Corporation de L'Ecole Polytechnique de Montreal, Montréal, Québec H3T 1J4 (CA)
(72) Inventeur: CHIAROTTO, Sébastien, 94220 Charenton-le-pont (FR); KLEMBERG-SAPIEHA, Jolanta, Montréal Québec H3T 1J4 (CA); CARON, Martin, Montréal Québec H3T 1J4 (CA)
(74) Mandataire: Jacobacci Coralis Harle
(86) Numéro de dépôt international: PCT/FR2016/053525
(87) Numéro de publication internationale: WO 2017/103537

(56) Documents cités:
- EP-A1- 0 402 473
- EP-A2- 1 123 905
- WO-A1-2005/024087
- JP-A- H03 143 975

## Description

La présente invention concerne d'une manière générale un article, de préférence un article d'optique, notamment une lentille ophtalmique, possédant une couche de nature organique/inorganique et de bas indice de réfraction, ainsi qu'un procédé de préparation d'un tel article.

Il est connu de traiter des lentilles ophtalmiques par des revêtements interférentiels.

En particulier, il est connu de traiter les lentilles ophtalmiques, qu'elles soient minérales ou organiques, de façon à empêcher la formation de reflets parasites gênants pour le porteur de la lentille et ses interlocuteurs. La lentille est alors pourvue d'un revêtement antireflet mono- ou multicouche, généralement en matière minérale, lequel présente dans le second cas une alternance de couches de haut indice de réfraction et de bas indice de réfraction.

Un revêtement réfléchissant réalise l'effet inverse, c'est-à-dire qu'il augmente la réflexion des rayons lumineux. Un tel type de revêtement est utilisé par exemple, pour obtenir un effet miroir dans des lentilles solaires.

Il est également connu d'utiliser des revêtements interférentiels pour filtrer certaines longueurs d'onde nocives pour l'œil, par exemple les longueurs d'onde dans le domaine du bleu. On peut aussi utiliser des revêtements antireflets ayant également une fonction de filtration dans une ou plusieurs gammes de longueurs d'ondes sélectionnées.

Lors du taillage et du montage d'un verre chez l'opticien, le verre subit des déformations mécaniques qui peuvent provoquer des fissures dans les revêtements interférentiels réfléchissants ou antireflet minéraux, en particulier lorsque l'opération n'est pas conduite avec soin. De façon similaire, des sollicitations en température (chauffage de la monture) peuvent provoquer des fissures dans le revêtement interférentiel. Selon le nombre et la taille des fissures, celles-ci peuvent gêner la vue pour le porteur et empêcher la commercialisation du verre. En outre, pendant le port de verres organiques traités, des rayures peuvent apparaître. Dans les revêtements interférentiels minéraux, certaines rayures entraînent des fissurations, rendant les rayures plus visibles à cause d'une diffusion de lumière.

Un objectif de l'invention est l'obtention d'un revêtement, notamment un revêtement interférentiel, et en particulier antireflet, ayant des propriétés thermomécaniques améliorées, tout en conservant un bas indice de réfraction, avec de préférence de bonnes propriétés d'adhérence. L'invention vise en particulier des articles possédant une température critique améliorée, c'est à dire, présentant une bonne résistance à la craquelure lorsqu'ils sont soumis à une élévation de température. Un autre objectif de l'invention est de disposer d'un procédé de fabrication d'un revêtement interférentiel simple, facile à mettre en œuvre et reproductible.

Il est également connu de déposer des couches minces organique / inorganique par voie liquide. Cette technique de dépôt présente des inconvénients tels que la difficulté d'étalement et de polymérisation des couches sans créer des craquelures sur des substrats organiques, la durée du procédé, en particulier lorsque d'autres revêtements doivent être déposés sur ces couches.

La demande WO-2005/024087, au nom du demandeur, décrit un procédé de réalisation d'un traitement antireflet sur un substrat optique qui comprend le dépôt physique en phase gazeuse sous vide d'une couche à bas indice de réfraction comprenant de la silice ou du fluorure de magnésium et un polymère fluoré. La couche obtenue a une adhérence améliorée à la couche sous-jacente d'un empilement antireflet déposé sur un substrat optique ou sur le substrat optique lui-même. Le dépôt n'est pas réalisé sous assistance ionique. En outre, il n'est pas envisagé d'utiliser un composé organosilicié à la place du polymère fluoré.

La demande EP-1.123.905 décrit un procédé pour former un film composite optique de haut ou bas indice de réfraction qui consiste à déposer un matériau inorganique, notamment SiO₂ et MgF₂ (matériaux bas indice) par placage réactif d'ions dans une atmosphère dans laquelle on introduit des substances gazeuses contenant un hydrocarbure fluoré. L'atmosphère peut en outre contenir un composé organosilicié. Des ions du matériau inorganique et des substances gazeuses sont directement formés dans la chambre par application d'une radiofréquence. La présence d'un composé organosilicié dans l'atmosphère a pour résultat d'accroître la stabilité du film composite obtenu. L'hydrocarbure fluoré est un constituant essentiel du procédé.

Il existe toujours un besoin de nouveaux matériaux pour les couches bas indice de réfraction des empilements interférentiels qui présentent des propriétés thermo-mécaniques améliorées tout en ayant un bas indice de réfraction.

Les articles préparés doivent de préférence présenter une bonne résistance à un traitement au trempé dans l'eau chaude suivi d'une sollicitation mécanique de surface, et être exempts de défauts optiques.

Ainsi, les inventeurs ont mis au point un matériau de couche de bas indice de réfraction, transparent, utilisable dans des filtres interférentiels, permettant de remplir les objectifs fixés. Ce matériau peut être utilisé pour remplacer des matériaux de bas indice de réfraction traditionnels tels que la silice et le fluorure de magnésium dans les revêtements interférentiels.

Selon l'invention, la couche de matériau de bas indice de réfraction est formée par dépôt sous vide sous assistance d'un faisceau d'ions, de préférence issu d'un canon à ions, d'espèces activées, sous forme gazeuse, obtenues à partir d'un matériau précurseur de nature organique et d'un matériau précurseur de nature inorganique. Elle possède des propriétés thermomécaniques améliorées tout en présentant un bas indice de réfraction et une transparence élevés.

Les buts fixés sont donc atteints selon l'invention par un article comprenant un substrat ayant au moins une surface principale revêtue d'une couche L d'un matériau M obtenu par dépôt sous vide, par co-évaporation, d'au moins un composé métallique A choisi parmi les fluorures des métaux alcalino-terreux et d'au moins un composé organique B, le matériau M ayant un indice de réfraction à la longueur d'onde de 632,8 nm allant de 1,38 à 1,45, caractérisé en ce que :
- le composé organique B est un composé organosilicié ou un mélange de composés organosiliciés, et
- le dépôt du composé B, sous forme gazeuse, est effectué en présence d'un bombardement ionique, de préférence au moyen d'un canon à ions.

De préférence, le composé organique B ne comporte aucun hydrocarbure fluoré. Mieux, le composé organique B est uniquement constitué d'un composé organosilicié ou d'un mélange de composés organosiliciés.

De préférence, le bombardement ionique du composé B organosilicié s'effectue en présence d'un gaz choisi parmi l'oxygène, les gaz rares, l'azote et un mélange de deux ou plus de ces gaz, en particulier d'oxygène ou d'un mélange d'oxygène et argon et/ou d'azote. De préférence encore, la co-évaporation du composé métallique A s'effectue au moyen d'un canon à électrons.

Dans une réalisation recommandée de l'invention, lorsque la couche L constitue la couche d'un revêtement interférentiel la plus éloignée du substrat, une mince couche organique-inorganique d'épaisseur 1 à 20 nm est déposée sur cette couche L, cette couche organique-inorganique étant obtenue par dépôt d'un composé organosilicié ou d'un mélange de composés organosiliciés sous forme gazeuse, en présence d'un bombardement ionique et en l'absence d'un précurseur minéral.

De préférence, cette mince couche organique-inorganique est obtenue uniquement par dépôt d'un composé organosilicié ou d'un mélange de composés organosiliciés.

Le dépôt d'une telle couche mince organique-inorganique sur la couche L, de manière surprenante, accroît l'adhésion de la couche L au revêtement interférentiel.

Les composés organiques-inorganiques utilisés pour cette mince couche organique-inorganique sont les mêmes que ceux utilisables pour la formation de la couche L. Les conditions de dépôt de cette couche mince organique-inorganique sont également semblables à celles utilisées pour le dépôt de la couche L selon l'invention. Par contre, le dépôt de la couche mince organique-inorganique est réalisé en l'absence de tout précurseur minéral, tel que la silice, les oxydes et halogénures métalliques, notamment les fluorures métalliques et, en particulier, SiO₂ et MgF₂. De préférence, le dépôt de la couche mince organique-inorganique est obtenu par dépôt des seuls composés organosiliciés.

La combinaison de la couche L et de la mince couche organique-inorganique a un indice de réfraction allant de 1,38 à 1,47 à la longueur d'onde de 632,8 mm.

L'invention concerne également un procédé de fabrication d'un tel article, comprenant au moins les étapes suivantes :
- fournir un article comprenant un substrat ayant au moins une surface principale,
- déposer sur ladite surface principale du substrat une couche L d'un matériau ayant un indice de réfraction allant de 1,38 à 1,47 à la longueur d'onde de 632,8 nm et, facultativement, le dépôt sur cette couche L d'une mince couche organique-inorganique de 1 à 20 nm d'épaisseur,
- récupérer un article comprenant un substrat ayant une surface principale revêtue d'une couche L,
ladite couche L ayant été obtenue par dépôt sous vide, par co-évaporation, d'au moins un composé métallique A choisi parmi les fluorures des métaux alcalino-terreux et d'un composé B comprenant au moins un composé organosilicié, le dépôt du composé B, sous forme gazeuse, étant effectué en présence d'un bombardement ionique, de préférence au moyen d'un canon à ions, et le dépôt de la mince couche organique-inorganique facultative étant obtenu par dépôt d'un composé organosilicié ou d'un mélange de composés organosiliciés, en l'absence de précurseur minéral. De préférence, la co-évaporation du composé métallique A est effectuée au moyen d'un canon à électrons.

Dans la présente demande, lorsqu'un article comprend un ou plusieurs revêtements à sa surface, l'expression "déposer une couche ou un revêtement sur l'article" signifie qu'une couche ou un revêtement est déposé sur la surface à découvert (exposée) du revêtement externe de l'article, c'est-à-dire son revêtement le plus éloigné du substrat.

Un revêtement qui est "sur" un substrat ou qui a été déposé "sur" un substrat est défini comme un revêtement qui (i) est positionné au-dessus du substrat, (ii) n'est pas nécessairement en contact avec le substrat (bien que préférentiellement, il le soit), c'est-à-dire qu'un ou plusieurs revêtements intermédiaires peuvent être disposés entre le substrat et le revêtement en question, et (iii) ne recouvre pas nécessairement le substrat complètement (bien que préférentiellement, il le recouvre). Lorsque "une couche 1 est localisée sous une couche 2", on comprendra que la couche 2 est plus éloignée du substrat que la couche 1.

L'article préparé selon l'invention comprend un substrat, de préférence transparent, ayant des faces principales avant et arrière, l'une au moins desdites faces principales comportant au moins une couche L, pouvant être intégrée dans un revêtement interférentiel, de préférence les deux faces principales.

Par face arrière (généralement concave) du substrat, on entend la face qui, lors de l'utilisation de l'article, est la plus proche de l'œil du porteur. Inversement, par face avant (généralement convexe) du substrat, on entend la face qui, lors de l'utilisation de l'article, est la plus éloignée de l'œil du porteur.

Bien que l'article selon l'invention puisse être un article quelconque, tel qu'un écran, un vitrage, des lunettes de protection utilisables notamment en environnement de travail, un miroir, ou un article utilisé en électronique, il constitue de préférence un article d'optique, mieux une lentille optique, et encore mieux une lentille ophtalmique, pour lunettes, ou une ébauche de lentille optique ou ophtalmique telle qu'une lentille optique semi-finie, en particulier un verre de lunettes. La lentille peut comporter une puissance optique, progressive ou multifocale, ou sans puissance (piano). La lentille peut être une lentille polarisée, colorée, une lentille photochrome ou électrochromique. Préférentiellement, la lentille ophtalmique selon l'invention présente une transmission élevée.

La couche L selon l'invention peut être formée sur au moins l'une des faces principales d'un substrat nu, c'est-à-dire non revêtu, ou sur au moins l'une des faces principales d'un substrat déjà revêtu d'un ou plusieurs revêtements fonctionnels.

Le substrat de l'article selon l'invention est de préférence un verre organique, par exemple en matière plastique thermoplastique ou thermodurcissable. Ce substrat peut être choisi parmi les substrats cités dans la demande WO-2008/062142, WO2008109154 par exemple un substrat obtenu par (co)polymérisation du bis allyl carbonate du diéthylèneglycol, un substrat en poly(thio)uréthane, un substrat en polyacrylate, un substrat en polyepisulfide ou un substrat en polycarbonate de bis(phénol A) (thermoplastique), noté PC, ou un substrat en PMMA (polyméthacrylate de méthyle).

Avant le dépôt de la couche L sur le substrat éventuellement revêtu, par exemple d'un revêtement anti-abrasion et/ou anti-rayures, il est courant de soumettre la surface dudit substrat, éventuellement revêtue, à un traitement d'activation physique ou chimique, destiné à augmenter l'adhésion de la couche L. Ce prétraitement est généralement conduit sous vide. Il peut s'agir d'un bombardement avec des espèces énergétiques et/ou réactives, par exemple un faisceau d'ions ("Ion Pre-Cleaning" ou "IPC") ou un faisceau d'électrons, d'un traitement par décharge corona, par effluvage, d'un traitement UV, ou d'un traitement par plasma sous vide, généralement un plasma d'oxygène ou d'argon. Il peut également s'agir d'un traitement de surface acide ou basique et/ou par solvants (eau ou solvant organique). Plusieurs de ces traitements peuvent être combinés. Grâce à ces traitements de nettoyage, la propreté et la réactivité de la surface du substrat sont optimisées.

Par espèces énergétiques (et/ou réactives), on entend notamment des espèces ioniques ayant une énergie allant de préférence de 1 à 300 eV, préférentiellement de 1 à 150 eV, mieux de 10 à 150 eV, et mieux encore de 40 à 150 eV. Les espèces énergétiques peuvent être des espèces chimiques telles que des ions, des radicaux, ou des espèces telles que des photons ou des électrons.

Le prétraitement préféré de la surface du substrat est un traitement par bombardement ionique, effectué au moyen d'un canon à ions, les ions étant des particules constituées d'atomes de gaz dont on a extrait un ou plusieurs électron(s). On utilise de préférence en tant que gaz ionisé l'argon (ions Ar⁺), mais également l'oxygène, ou leurs mélanges, sous une tension d'accélération allant généralement de 50 à 200 V, une densité de courant généralement comprise entre 10 et 100 µA/cm² sur la surface activée, et généralement sous une pression résiduelle dans l'enceinte à vide pouvant varier de 8.10⁻⁵ mbar à 5.10⁻⁴ mbar.

L'article selon l'invention comporte une couche L, qui constitue de préférence une couche bas indice d'un revêtement interférentiel multicouche, notamment antireflet. De préférence, la couche externe d'un tel revêtement (interférentiel) multicouche, c'est-à-dire la couche du revêtement (interférentiel) la plus éloignée du substrat dans l'ordre d'empilement, est une couche L selon l'invention. Dans un mode de réalisation préféré, la couche L constitue la dernière couche du revêtement (interférentiel) multicouche dans l'ordre d'empilement et se trouve directement en contact avec une couche sous-jacente de haut indice de réfraction.

La couche L ou ledit revêtement (interférentiel) multicouche est formée de préférence sur un revêtement anti-abrasion. Les revêtements anti-abrasion préférés sont des revêtements à base d'hydrolysats d'époxysilane comportant au moins deux groupements hydrolysables, de préférence au moins trois, liés à l'atome de silicium. Les groupements hydrolysables préférés sont des groupements alcoxysilane.

Le revêtement interférentiel peut être tout revêtement interférentiel classiquement utilisé dans le domaine de l'optique, en particulier de l'optique ophtalmique, excepté le fait qu'il comporte une couche L selon l'invention. Le revêtement interférentiel peut être, sans limitation, un revêtement antireflet, un revêtement réfléchissant (miroir), de préférence un revêtement antireflet.

Un revêtement antireflet se définit comme un revêtement, déposé à la surface d'un article, qui améliore les propriétés anti-réfléchissantes de l'article final. Il permet de réduire la réflexion de la lumière à l'interface article-air sur une portion relativement large du spectre visible.

Comme cela est bien connu, les revêtements interférentiels, de préférence les revêtements antireflet, comprennent classiquement un empilement monocouche ou multicouche de matériaux diélectriques. Ce sont de préférence des revêtements multicouches, comprenant des couches de haut indice de réfraction (HI) et des couches de bas indice de réfraction (BI).

Dans la présente demande, une couche du revêtement interférentiel est dite couche de haut indice de réfraction lorsque son indice de réfraction est supérieur à 1,55, de préférence supérieur ou égal à 1,6, mieux supérieur ou égal à 1,8 et encore mieux supérieur ou égal à 2,0. Une couche d'un revêtement interférentiel est dite couche de bas indice de réfraction lorsque son indice de réfraction est inférieur ou égal à 1,55, de préférence inférieur ou égal à 1,50, mieux inférieur ou égal à 1,45. Sauf indication contraire, les indices de réfraction auxquels il est fait référence dans la présente invention sont exprimés à 25°C pour une longueur d'onde de 550 nm.

Les couches HI sont des couches de haut indice de réfraction classiques, bien connues dans la technique. Elles comprennent généralement un ou plusieurs oxydes minéraux tels que, sans limitation, la zircone (ZrO₂), le dioxyde de titane (TiO₂), le pentoxyde de tantale (Ta₂O₅), l'oxyde de néodyme (Nd₂O₅), l'oxyde d'hafnium (HfO₂), l'oxyde de praséodyme (Pr₂O₃), le titanate de praséodyme (PrTiO₃), La₂O₃, Nb₂O₅, Y₂O₃, l'oxyde d'indium In₂O₃, ou l'oxyde d'étain SnO₂. Les matériaux préférés sont TiO₂, Ta₂O₅, PrTiO₃, ZrO₂, SnO₂, In₂O₃ et leurs mélanges.

Les couches BI sont également bien connues et peuvent comprendre, sans limitation, SiO₂, MgF₂, ZrF₄, de l'alumine (Al₂O₃) en faible proportion, AlF₃, et leurs mélanges, de préférence SiO₂. On peut également utiliser des couches SiOF (SiO₂ dopée au fluor).

Généralement, les couches HI ont une épaisseur physique variant de 10 à 120 nm, et les couches BI ont une épaisseur physique variant de 10 à 120 nm, préférentiellement 10 à 110 nm.

Préférentiellement, l'épaisseur totale du revêtement interférentiel est inférieure à 1 micromètre, mieux inférieure ou égale à 800 nm et mieux encore inférieure ou égale à 500 nm. L'épaisseur totale du revêtement interférentiel est généralement supérieure à 100 nm, de préférence supérieure à 150 nm.

De préférence encore, le revêtement interférentiel, qui est de préférence un revêtement antireflet, comprend au moins deux couches de bas indice de réfraction (BI) et au moins deux couches de haut indice de réfraction (HI). Préférentiellement, le nombre total de couches du revêtement interférentiel est inférieur ou égal à 8, mieux inférieur ou égal à 6.

Il n'est pas nécessaire que les couches HI et BI soient alternées dans le revêtement interférentiel, bien qu'elles puissent l'être selon un mode de réalisation de l'invention. Deux couches HI (ou plus) peuvent être déposées l'une sur l'autre, tout comme deux couches BI (ou plus) peuvent être déposées l'une sur l'autre.

Selon l'invention, les couches L constituent généralement des couches de bas indice de réfraction. Le revêtement interférentiel selon l'invention peut renfermer une ou plusieurs couches L. Selon un mode de réalisation de l'invention, les couches L constituent la totalité des couches de bas indice de réfraction du revêtement interférentiel.

Dans un premier mode de réalisation, toutes les couches bas indice de réfraction du revêtement interférentiel sont des couches L.

Dans un autre mode de réalisation de l'invention, toutes les couches de bas indice de réfraction du revêtement interférentiel selon l'invention sont de nature inorganique à l'exception d'une couche L (c'est à dire que les autres couches de bas indice de réfraction du revêtement interférentiel ne contiennent de préférence pas de composé organique).

De préférence, toutes les couches du revêtement interférentiel selon l'invention sont de nature inorganique, à l'exception de la couche L, ce qui signifie que la couche L constitue de préférence la seule couche de nature organique-inorganique du revêtement interférentiel de l'invention (les autres couches du revêtement interférentiel ne contenant de préférence pas de composé organique).

De préférence, la couche L constitue la couche externe du revêtement interférentiel.

Selon un mode de réalisation de l'invention, le revêtement interférentiel comprend une sous-couche. Elle constitue dans ce cas généralement la première couche de ce revêtement interférentiel dans l'ordre de dépôt des couches, c'est-à-dire la couche du revêtement interférentiel qui est au contact du revêtement sous-jacent (qui est généralement un revêtement anti-abrasion et/ou anti-rayures) ou du substrat, lorsque le revêtement interférentiel est directement déposé sur le substrat.

Par sous-couche du revêtement interférentiel, on entend un revêtement d'épaisseur relativement importante, utilisé dans le but d'améliorer la résistance à l'abrasion et/ou aux rayures dudit revêtement et/ou de promouvoir son adhésion au substrat ou au revêtement sous-jacent. La sous-couche selon l'invention peut être choisie parmi les sous-couches décrites dans la demande WO-2010/109154. Préférentiellement, la sous-couche a une épaisseur de 100 à 500 nm. Dans un autre mode de réalisation de l'invention, la sous-couche a une épaisseur de 150 à 400 nm, de préférence de 150 à 300 nm Elle est préférentiellement de nature exclusivement minérale/inorganique et est préférentiellement constituée de silice SiO₂.

L'article de l'invention peut être rendu antistatique grâce à l'incorporation, de préférence dans le revêtement interférentiel, d'au moins une couche électriquement conductrice. Par "antistatique", on entend la propriété de ne pas retenir et/ou développer une charge électrostatique appréciable. Un article est généralement considéré comme ayant des propriétés antistatiques acceptables lorsqu'il n'attire et ne fixe pas la poussière et les petites particules après que l'une de ses surfaces a été frottée au moyen d'un chiffon approprié.

La nature et la localisation dans l'empilement de la couche électriquement conductrice pouvant être utilisée dans l'invention sont décrites plus en détail dans la demande WO-2013/098531. Il s'agit de préférence d'une couche de 1 à 20 nm d'épaisseur comprenant de préférence au moins un oxyde métallique choisi parmi l'oxyde d'étain-indium (In₂O₃:Sn, oxyde d'indium dopé à l'étain noté ITO), l'oxyde d'indium (In₂O₃), et l'oxyde d'étain (SnO₂).

Les différentes couches du revêtement interférentiel (dont fait partie la couche L antistatique optionnelle) autres que la ou les couches L sont préférentiellement déposées par dépôt sous vide selon l'une des techniques suivantes : i) par évaporation, éventuellement assistée par faisceau ionique ; ii) par pulvérisation par faisceau d'ion ; iii) par pulvérisation cathodique ; iv) par dépôt chimique en phase vapeur assisté par plasma. Ces différentes techniques sont décrites dans les ouvrages "Thin Film Processes" and "Thin Film Processes II," Vossen & Kern, Ed., Academic Press, 1978 et 1991 respectivement. Une technique particulièrement recommandée est la technique d'évaporation sous vide. De préférence, le dépôt de chacune des couches du revêtement interférentiel est réalisé par évaporation sous vide.

La couche L constitue généralement une couche de bas indice de réfraction au sens de l'invention, du fait de son indice de réfraction inférieur ou égal à 1,47. De préférence, selon des modes de réalisation de l'invention, l'indice de réfraction de la couche L varie de 1,38 à 1,47. Il y a lieu de noter que l'indice de réfraction de la couche L est mesuré à la longueur d'onde de 632,8 nm à une température T = 20-25°C.

Des gammes d'indice de réfraction correspondant à d'autres modes de réalisation de l'invention sont les gammes suivantes :
1,38 à 1,45 ; 1,38 à 1,44, 1,38 à 1,43 ; 1,38 à 1,42.

La couche L est formée d'un matériau obtenu par dépôt sous vide, par co-évaporation d'au moins un fluorure de métal alcalino-terreux, de préférence MgF₂ et d'au moins un composé B organosilicié.

De préférence, le dépôt est effectué dans une enceinte à vide, comportant un canon à ions dirigé vers les substrats à revêtir, qui émet vers ceux-ci un faisceau d'ions positifs générés dans un plasma au sein du canon à ions. Préférentiellement les ions issus du canon à ions sont des particules constituées d'atomes de gaz dont on a extrait un ou plusieurs électron(s), et formés à partir d'un gaz rare, d'oxygène, d'azote ou d'un mélange de deux ou plus de ces gaz.

Des précurseurs du composé B silico-organique sont introduits ou passent dans un état gazeux dans l'enceinte à vide. Ils sont de préférence amenés en direction du faisceau d'ions et sont activés sous l'effet du canon à ions.

Cette technique de dépôt utilisant un canon à ions et un précurseur gazeux, parfois désignée par « ion beam déposition » est décrite notamment, avec des seuls précurseurs organiques dans le brevet US 5508368.

Selon l'invention, de façon préférentielle, le seul endroit de l'enceinte où un plasma est généré est le canon à ions.

Les ions peuvent faire l'objet, le cas échéant, d'une neutralisation avant la sortie du canon à ions. Dans ce cas, le bombardement sera toujours considéré comme ionique. Le bombardement ionique provoque un réarrangement atomique et une densification dans la couche en cours de dépôt, ce qui permet de la tasser pendant qu'elle est en train d'être formée.

Lors de la mise en œuvre du procédé selon l'invention, la surface à traiter est préférentiellement bombardée par des ions, d'une densité de courant généralement comprise entre 20 et 1000 µA/cm², préférentiellement entre 30 et 500 µA/cm², mieux entre 30 et 200 µA/cm² sur la surface activée et généralement sous une pression résiduelle dans l'enceinte à vide pouvant varier de 6.10⁻⁵ mbar à 5.10⁻⁴ mbar, préférentiellement de 8.10⁻⁵ mbar à 5.10⁻⁴ mbar. On utilise de préférence un faisceau d'ions oxygène, argon, azote ou d'un mélange de deux ou plus de ces gaz. Lorsqu'un mélange d'argon et d'oxygène est employé, le ratio molaire Ar / O₂ est de préférence ≤ 1, mieux ≤ 0,75 et encore mieux ≤ 0,5. Ce ratio peut être contrôlé en ajustant les débits de gaz dans le canon à ions. Les débits des gaz varient de préférence de 0 à 30 sccm.

Les ions du faisceau d'ions, préférentiellement issus d'un canon à ions, utilisés au cours du dépôt de la couche L ont de préférence une énergie allant de 5eV à 1000 eV, mieux de 5 à 500 eV, préférentiellement 75 à 150 eV, préférentiellement de 80 à 140 eV, mieux de 90 à 110 eV. Les espèces activées formées sont typiquement des radicaux ou des ions.

En cas de bombardement ionique lors du dépôt, il est possible d'effectuer un traitement par plasma concomitamment ou non au dépôt sous faisceau d'ions de la couche L. Dans un autre mode de réalisation , le dépôt de la couche est effectué sans l'assistance d'un plasma au niveau des substrats.

Le dépôt de ladite couche L s'effectue en présence d'une source d'oxygène lorsque le composé B précurseur ne contient pas (ou pas suffisamment) d'atomes d'oxygène et que l'on souhaite que la couche L contienne une certaine proportion d'oxygène. De même, le dépôt de ladite couche L s'effectue en présence d'une source d'azote lorsque le composé B précurseur ne contient pas (ou pas suffisamment) d'atomes d'azote et que l'on souhaite que la couche L contienne une certaine proportion d'azote.

D'une manière générale, on préfère introduire du gaz oxygène avec le cas échéant une faible teneur en gaz azote, de préférence en l'absence de gaz azote.

Outre la couche L, d'autres couches du revêtement interférentiel peuvent être déposées sous bombardement ionique tel que décrit ci-dessus, c'est-à-dire en utilisant un bombardement au moyen d'un faisceau d'ions de la couche en cours de formation, émis de préférence par un canon à ions.

La méthode préférée pour la vaporisation des matériaux précurseurs de la couche L, conduite sous vide, est le dépôt physique en phase vapeur, en particulier l'évaporation sous vide, généralement combinée à un chauffage des composés à évaporer. Elle peut être mise en jeu en utilisant des systèmes d'évaporation aussi divers qu'une source thermique à effet Joule (l'effet Joule est la manifestation thermique de la résistance électrique) ou un canon à électrons pour les précurseurs liquides ou solides, tout autre dispositif connu de l'homme du métier pouvant également être utilisé.

Le composé B précurseur de la couche L est de préférence introduit dans l'enceinte à vide dans laquelle est réalisée la préparation des articles selon l'invention sous forme gazeuse, en contrôlant son débit. Ceci signifie qu'il n'est de préférence pas vaporisé à l'intérieur de l'enceinte à vide (contrairement au fluorure de métal alcalino-terreux). L'alimentation en composé B précurseur de la couche L se situe à une distance de la sortie du canon à ions variant de préférence de 30 à 50 cm.

De préférence, le fluorure de métal alcalino-terreux, notamment MgF₂ est préchauffé de manière à se trouver dans un état fondu puis évaporé. Il est de préférence déposé par évaporation sous vide en utilisant un canon à électrons pour provoquer sa vaporisation.

Le composé B précurseur et le composé métallique A, typiquement MgF₂, sont de préférence déposés de façon concomitante (par exemple par co-évaporation) ou partiellement concomitante, c'est-à-dire avec chevauchement des étapes de dépôt de l'un et de l'autre précurseur. Dans ce dernier cas, le dépôt de l'un des deux précurseurs commence avant le dépôt de l'autre, le dépôt du second précurseur débutant avant la fin du dépôt du premier précurseur.

Le composé B organosilicié, précurseur de la couche L, est de nature organique, et contient dans sa structure au moins un atome de silicium et au moins un atome de carbone. Il comporte de préférence au moins une liaison Si-C, et comporte de préférence au moins un atome d'hydrogène. Selon un mode de réalisation, le composé B comprend au moins un atome d'azote et/ou au moins un atome d'oxygène, de préférence au moins un atome d'oxygène.

La concentration de chaque élément chimique dans la couche L (Ti, Si, O, C, H, N...) peut être déterminée en utilisant la technique RBS (Rutherford Backscattering Spectrometry), et ERDA (Elastic Recoil Detection Analysis).

Des exemples non limitatifs de composés organiques B, cycliques ou non cycliques, sont les composés suivants : l'octaméthylcyclotétrasiloxane (OMCTS), le décaméthylcyclopentasiloxane, le dodécaméthylcyclohexasiloxane, l'hexaméthyl cyclotrisiloxane, l'hexaméthyldisiloxane (HMDSO), l'octaméthyltrisiloxane, le décaméthyltétrasiloxane (DMTS), le dodécaméthylpentasiloxane, le tétraéthoxysilane, le vinyltriméthylsilane, l'hexaméthyldisilazane, l'hexaméthyldisilane, l'hexaméthylcyclotrisilazane, le vinylméthyldiéthoxysilane, le divinyltétraméthyldisiloxane, le tétraméthyldisiloxane., le polydiméthylsiloxane (PDMS), le poly-phénylméthylsiloxane (PPMS) ou un tétraalkylsilane tel que le tétraméthylsilane,

De préférence, le composé B comporte au moins un atome de silicium porteur d'au moins un groupe alkyle, de préférence en C1-C4, mieux au moins un atome de silicium porteur d'un ou de deux groupes alkyle identiques ou différents, de préférence en C1-C4, par exemple le groupe méthyle.

Les composés B précurseurs de la couche L préférés comportent un groupe Si-O-Si, mieux, un groupe divalent de formule (3) : 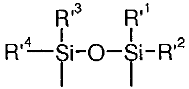 où R'¹ à R'⁴ désignent indépendamment des groupes alkyle ou vinyle linéaires ou ramifiés, de préférence en C1-C4, par exemple le groupe méthyle, des groupes aryle monocyclique ou polycyclique, hydroxyle ou des groupes hydrolysables. Des exemples non limitatifs de groupes hydrolysables sont les groupes H, halogène (chloro, bromo, iodo...), alcoxy, aryloxy, acyloxy, - NR¹R² où R¹ et R² désignent indépendamment un atome d'hydrogène, un groupe alkyle ou un groupe aryle, et -N(R³)-Si où R³ désigne un atome d'hydrogène, un groupe alkyle linéaire ou ramifié, de préférence en C1-C4 ou un groupe aryle, monocyclique ou polycyclique, de préférence monocyclique. Les groupes comportant un chaînon Si-O-Si ne sont pas considérés comme étant des "groupes hydrolysables" au sens de l'invention. Le groupe hydrolysable préféré est l'atome d'hydrogène.

Selon un autre mode de réalisation, le composé B précurseur de la couche L répond à la formule : 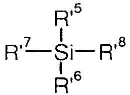 dans laquelle R'5, R'6, R'7, R'8 désignent indépendamment des groupes hydroxyle ou des groupes hydrolysables tels que des groupes OR, dans lesquels R est un groupe alkyle.

Selon un premier mode de réalisation, le composé B comporte au moins un atome de silicium porteur de deux groupes alkyle identiques ou différents, de préférence en C1-C4. Selon ce premier mode de réalisation, le composé B est de préférence un composé de formule (3) dans laquelle R'¹ à R'⁴ désignent indépendamment des groupes alkyle, de préférence en C1-C4, par exemple le groupe méthyle.

De préférence, le ou les atomes de silicium du composé B ne comportent aucun groupe hydrolysable ou groupe hydroxyle dans ce mode de réalisation.

Le ou les atomes de silicium du composé B précurseur de la couche L sont de préférence uniquement liés à des groupes alkyle et/ou des groupes comportant un chaînon -O-Si ou -NH-Si de façon à former un groupe Si-O-Si ou Si-NH-Si. Les composés précurseurs de la couche L préférés sont le DMTS, l'OMCTS et le HMDSO.

Il s'agit préférentiellement d'un polysiloxane cyclique de formule (4) : 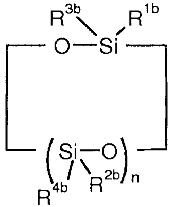 où n désigne un entier allant de 2 à 20, de préférence de 3 à 8, R^{1b} à R^{4b} représentent indépendamment des groupes alkyle linéaires ou ramifiés, de préférence en C1-C4 (par exemple le groupe méthyle), vinyle, aryle ou un groupe hydrolysable. Les membres préférés appartenant à ce groupe sont les octa-alkylcyclotétrasiloxanes (n = 3), de préférence l'octaméthylcyclotétrasiloxane (OMCTS). Dans certains cas, la couche L est issue d'un mélange d'un certain nombre de composés de formule (4) où n peut varier dans les limites indiquées ci-dessus.

Selon un second mode de réalisation, le composé B contient dans sa structure au moins un groupe Si-X', où X' est un groupe hydroxy ou un groupe hydrolysable, qui peut être choisi, sans limitation, parmi les groupes H, halogène, alcoxy, aryloxy, acyloxy, -NR¹R² où R¹ et R² désignent indépendamment un atome d'hydrogène, un groupe alkyle ou un groupe aryle, et - N(R³)-Si où R³ désigne un atome d'hydrogène, un groupe alkyle ou un groupe aryle.

Selon ce second mode de réalisation de l'invention, le composé B contient de préférence dans sa structure au moins un groupe Si-H, c'est-à-dire constitue un hydrure de silicium. De préférence, l'atome de silicium du groupe Si-X' n'est pas lié à plus de deux groupes non hydrolysables tels que des groupes alkyle ou aryle.

Parmi les groupes X', les groupes acyloxy ont préférentiellement pour formule -OC(O)R⁴ où R⁴ est un groupe aryle préférentiellement en C6-C12, éventuellement substitué par un ou plusieurs groupes fonctionnels, ou alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle, les groupes aryloxy et alcoxy ont pour formule -O-R⁵ où R⁵ est un groupe aryle préférentiellement en C6-C12, éventuellement substitué par un ou plusieurs groupes fonctionnels, ou alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle, les halogènes sont préférentiellement F, Cl, Br ou I, les groupes X' de formule -NR¹R² peuvent désigner un groupe amino NH₂, alkylamino, arylamino, dialkylamino, diarylamino, R¹ et R² désignant indépendamment un atome d'hydrogène, un groupe aryle préférentiellement en C6-C12, éventuellement substitué par un ou plusieurs groupes fonctionnels, ou un groupe alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle, les groupes X' de formule -N(R³)-Si sont rattachés à l'atome de silicium par l'intermédiaire de leur atome d'azote et leur atome de silicium comporte naturellement trois autres substituants, où R³ désigne un atome d'hydrogène, un groupe aryle préférentiellement en C6-C12, éventuellement substitué par un ou plusieurs groupes fonctionnels, ou un groupe alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle.

Le groupe acyloxy préféré est le groupe acétoxy. Le groupe aryloxy préféré est le groupe phénoxy. Le groupe halogène préféré est le groupe Cl. Les groupes alcoxy préférés sont les groupes méthoxy et éthoxy.

Dans le second mode de réalisation, le composé B comporte de préférence au moins un atome de silicium porteur d'au moins un groupe alkyle, de préférence en C1-C4 linéaire ou ramifié, mieux au moins un atome de silicium porteur d'un ou de deux groupes alkyle identiques ou différents, de préférence en C1-C4, et d'un groupe X' (de préférence un atome d'hydrogène) directement lié à l'atome de silicium, X' ayant la signification indiquée précédemment. Le groupe alkyle préféré est le groupe méthyle. Le groupe vinyle peut également être utilisé à la place d'un groupe alkyle. De préférence, l'atome de silicium du groupe Si-X' est directement lié à au moins un atome de carbone.

De préférence, chaque atome de silicium du composé B n'est pas lié directement à plus de deux groupes X', mieux n'est pas lié directement à plus d'un groupe X' (de préférence un atome d'hydrogène), mieux, chaque atome de silicium du composé B est lié directement à un seul groupe X' (de préférence un atome d'hydrogène). De préférence, le composé B comporte un ratio atomique Si/O égal à 1. De préférence, le composé B comporte un ratio atomique C/Si <2, préférentiellement ≤ 1,8, mieux ≤ 1,6 et mieux encore ≤ 1,5, ≤ 1, 3 et de façon optimale égal à 1. De préférence encore, le composé B comporte un ratio atomique C/O égal à 1. Selon un mode de réalisation, le composé B ne comporte pas de groupe Si-N, mieux ne comporte pas d'atome d'azote.

Le ou les atomes de silicium du composé B précurseur de la couche L sont de préférence uniquement liés à des groupes alkyle, hydrogène et/ou des groupes comportant un chaînon -O-Si ou -NH-Si de façon à former un groupe Si-O-Si ou Si-NH-Si. Dans un mode de réalisation, le composé B comporte au moins un groupe Si-O-Si-X' ou au moins un groupe Si-NH-Si-X', X' ayant la signification indiquée précédemment et représentant de préférence un atome d'hydrogène.

Selon ce second mode de réalisation, le composé B est de préférence un composé de formule (3) dans laquelle l'un au moins de R'¹ à R'⁴ désigne un groupe X' (de préférence un atome d'hydrogène), X' ayant la signification indiquée précédemment.

Selon ce second mode de réalisation, le composé B est préférentiellement un polysiloxane cyclique de formule (5) : 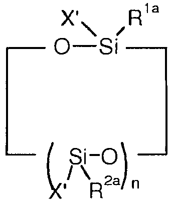 où X' a la signification indiquée précédemment et représente de préférence un atome d'hydrogène, n désigne un entier allant de 2 à 20, de préférence de 3 à 8, R^{1a} et R^{2a} représentent indépendamment un groupe alkyle de préférence en C1-C4 (par exemple le groupe méthyle), vinyle, aryle ou un groupe hydrolysable. Des exemples non limitatifs de groupes X' hydrolysables sont les groupes chloro, bromo, alcoxy, acyloxy, aryloxy, H. Les membres les plus courants appartenant à ce groupe sont les tétra-, penta- et hexaalkylcyclotétrasiloxanes, de préférence les tétra-, penta- et hexa-méthylcyclotétrasiloxanes, le 2,4,6,8-tétraméthylcyclotétrasiloxane (TMCTS) étant le composé préféré. Dans certains cas, la couche L est issue d'un mélange d'un certain nombre de composés ayant la formule ci-dessus où n peut varier dans les limites indiquées ci-dessus.

Selon un autre mode de réalisation, le composé B est un alkylhydrosiloxane linéaire, mieux un méthylhydrosiloxane linéaire tel que par exemple le 1,1,1,3,5,7,7,7-octaméthyl tétrasiloxane, le 1,1,1,3,5,5,5-heptaméthyltrisiloxane, le 1,1,3,3,5,5-hexaméthyl trisiloxane.

Des exemples non-limitatifs de composés organiques B précurseurs de la couche L, cycliques ou non cycliques, conformes au second mode de réalisation, sont les composés suivants : le 2,4,6,8-tétraméthylcyclotétrasiloxane (TMCTS de formule (1)), le 2,4,6,8-tétraéthylcyclotétrasiloxane, le 2,4,6,8-tétraphénylcyclotétrasiloxane, le 2,4,6,8-tétraoctylcyclotétrasiloxane, le 2,2,4,6,6,8-hexaméthylcyclotétrasiloxane, le 2,4,6-triméthylcyclotrisiloxane, le cyclotétrasiloxane, le 1,3,5,7,9-pentaméthyl cyclopentasiloxane, le 2,4,6,8,10-hexaméthylcyclohexasiloxane, le 1,1,1,3,5,7,7,7-octaméthyl tétrasiloxane, le 1,1,3,3,5,5-hexaméthyltrisiloxane, le tétraméthyldisiloxane, le tétraéthoxysilane, le vinylméthyldiéthoxysilane, un hexaméthylcyclotrisilazane tel que le 3,4,5,6-hexaméthylcyclotrisilazane ou le 2,2,4,4,6,6-hexaméthylcyclotrisilazane, le 1,1,1,3,5,5,5-heptaméthyl trisiloxane, le tris(trimethylsiloxy)silane (de formule (2)), le 1,1,3,3-tétraméthyldisilazane, le 1,2,3,4,5,6,7,8-octaméthylcyclotétrasilazane, le nonaméthyl trisilazane, le tris(diméthylsilyl)amine, l'hexaméthyldisilazane.

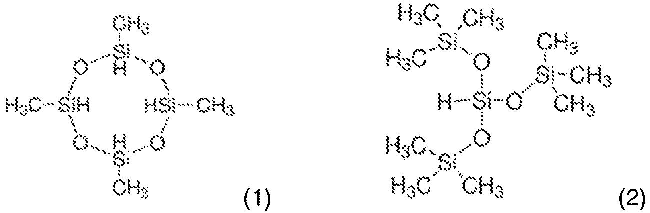

Le fluorure de métal alcalino-terreux de la couche L est de préférence le fluorure de magnésium MgF₂.

L'utilisation d'au moins un composé B pour former la couche L, qui comporte notamment des liaisons Si-C et éventuellement Si-O, permet de bénéficier de propriétés thermomécaniques améliorées par rapport aux matériaux de bas indice de réfraction traditionnels tels que SiO₂ ou MgF₂, notamment la tenue à la température et la résistance à la rayure des substrats revêtus par les couches L selon l'invention permettent d'atteindre des niveaux jusque-là inaccessibles par les technologies traditionnelles telles que le dépôt de couches purement inorganiques sous assistance ionique.

Selon un mode de réalisation de l'invention, la couche L comprend plus de 80 % en masse de composés issus du composé B et du fluorure de métal alcalino-terreux selon l'invention, par rapport à la masse totale de la couche L, de préférence plus de 90 %. Selon un mode de réalisation, la couche L est exclusivement formée par dépôt sous vide et sous bombardement ionique d'au moins un fluorure de métal alcalino-terreux et d'au moins un composé B organosilicié, à l'exclusion de tout autre précurseur.

De préférence, la couche L ne contient pas une phase distincte d'oxydes métalliques. La couche L étant formée par dépôt sous vide, elle ne comprend pas d'hydrolysat de composé organosilicié et se distingue donc des revêtements sol-gel obtenus par voie liquide.

La durée du processus de dépôt, les débits et pressions sont ajustés de façon à obtenir l'épaisseur de revêtement désirée.

La couche L possède une épaisseur allant jusqu'à 300 nm et de préférence de 20 à 150 nm, mieux de 25 à 120 nm et encore mieux de 60 à 100 nm.

La nature des composés employés, leurs quantités respectives (qui peuvent être modulées en ajustant les débits évaporés), et la durée du dépôt sont des exemples de paramètres que l'homme du métier saura faire varier pour parvenir au revêtement ayant les propriétés souhaitées, en particulier à l'aide des exemples de la présente demande.

Les articles selon l'invention présentent une bonne résistance à la fracture.

Ainsi, la température critique d'un article revêtu selon l'invention est de préférence supérieure ou égale à 70°C, mieux supérieure ou égale à 80°C et encore mieux supérieure ou égale à 90°C. Dans la présente demande, la température critique d'un article ou d'un revêtement est définie comme étant celle à partir de laquelle on observe l'apparition de craquelures dans l'empilement présent à la surface du substrat, ce qui traduit une dégradation du revêtement. Cette température critique élevée est due à la présence de la couche L à la surface de l'article, comme démontré dans la partie expérimentale. Par ailleurs, les couches L obtenues possèdent une aptitude plus faible à se charger en eau que des couches inorganiques évaporées. Les couches L obtenues selon l'invention, intégrées ou non dans un revêtement interférentiel ont une excellente stabilité dans le temps de leurs propriétés optiques.

Grâce à ses propriétés thermomécaniques améliorées, la couche L, faisant partie ou non d'un revêtement interférentiel, peut notamment être appliquée sur une seule face d'une lentille semi-finie, généralement sa face avant, l'autre face de cette lentille devant encore être usinée et traitée. L'empilement présent sur la face avant de la lentille ne sera pas dégradé par l'accroissement de température générée par les traitements que subira la face arrière lors du durcissement des revêtements qui auront été déposés sur cette face arrière ou toute autre action susceptible d'augmenter la température de la lentille.

Selon un mode de réalisation préféré, le revêtement interférentiel de l'invention est un revêtement antireflet comprenant, dans l'ordre de dépôt sur la surface du substrat éventuellement revêtu, une couche de ZrO₂, généralement de 10 à 40 nm d'épaisseur et préférentiellement de 15 à 35 nm, une couche de SiO₂, généralement de 10 à 40 nm d'épaisseur et préférentiellement de 15 à 35 nm, une couche L, généralement de 40 à 150 nm d'épaisseur, préférentiellement de 50 à 120 nm, une couche d'ITO ou de SnO₂, généralement de 1 à 15 nm d'épaisseur et préférentiellement de 2 à 10 nm, et une couche de SiO₂, généralement de 50 à 150 nm d'épaisseur et préférentiellement de 60 à 100 nm.

Dans un mode de réalisation de l'invention, le facteur moyen de réflexion dans le domaine visible (400-700 nm) d'un article revêtu d'un revêtement interférentiel selon l'invention, noté Rₘ, est inférieur à 2,5 % par face, mieux inférieur à 2 % par face et encore mieux inférieur à 1 % par face de l'article. Dans un mode de réalisation optimal, l'article comprend un substrat dont les deux surfaces principales sont revêtues d'un revêtement interférentiel selon l'invention et présente une valeur de Rₘ totale (cumul de réflexion due aux deux faces) inférieure à 1%. Les moyens pour parvenir à de telles valeurs de Rₘ sont connus de l'homme du métier.

Dans un autre mode de réalisation de l'invention, le facteur de réflexion lumineux Rᵥ d'un revêtement interférentiel selon l'invention est inférieur à 2,5 % par face, de préférence inférieur à 2 % par face, mieux inférieur à 1 % par face de l'article, mieux ≤ 0,75 %, mieux encore ≤ 0,5 %.

Dans la présente demande, le "facteur moyen de réflexion" Rₘ (moyenne de la réflexion spectrale sur l'ensemble du spectre visible entre 400 et 700 nm) et le facteur de réflexion lumineux Rᵥ sont tels que définis dans la norme ISO 13666:1998, et mesurés conformément à la norme ISO 8980-4.

Dans certaines applications, il est préférable que la surface principale du substrat soit revêtue d'un ou plusieurs revêtements fonctionnels préalablement au dépôt de la couche L ou du revêtement multicouche comprenant la couche L. Ces revêtements fonctionnels classiquement utilisés en optique peuvent être, sans limitation, une couche de primaire améliorant la résistance au choc et/ou l'adhésion des couches ultérieures dans le produit final, un revêtement anti-abrasion et/ou anti-rayures, un revêtement polarisé, un revêtement photochromique, électrochromique ou un revêtement coloré, en particulier une couche de primaire revêtue d'une couche L anti-abrasion et/ou anti-rayures. Ces deux derniers revêtements sont décrits plus en détail dans les demandes WO-2008/015364 et WO-2010/109154 et EP614957.

L'article selon l'invention peut également comporter des revêtements formés sur la couche L ou le revêtement multicouche la comprenant, capables de modifier ses propriétés de surface, tels qu'un revêtement hydrophobe et/ou oléophobe (top coat antisalissure) ou un revêtement antibuée. Ces revêtements sont de préférence déposés sur la couche L ou la couche externe d'un revêtement interférentiel. Leur épaisseur est en général inférieure ou égale à 10 nm, de préférence de 1 à 10 nm, mieux de 1 à 5 nm. Ils sont respectivement décrits dans les demandes WO-2009/047426 et WO-2011/080472.

Les revêtements hydrophobes et/ou oléophobes sont définis comme des revêtements dont l'angle de contact statique avec de l'eau désionisée est supérieur ou égal à 75°, de préférence supérieur ou égal à 90°, et mieux supérieur ou égal à 100°. Dans la présente demande, les angles de contact statiques peuvent être déterminés selon la méthode de la goutte de liquide, selon laquelle une goutte de liquide ayant un diamètre inférieur à 2 mm est déposée doucement sur une surface solide non absorbante et l'angle à l'interface entre le liquide et la surface solide est mesuré.

Le revêtement hydrophobe et/ou oléophobe est de préférence un revêtement de type fluorosilane ou fluorosilazane. Il peut être obtenu par dépôt d'un fluorosilane ou fluorosilazane précurseur, comprenant de préférence au moins deux groupes hydrolysables par molécule. Les fluorosilanes précurseurs contiennent préférentiellement des groupements fluoropolyéthers et mieux des groupements perfluoropolyéthers.

De préférence, le revêtement externe hydrophobe et/ou oléophobe a une énergie de surface égale ou inférieure à 14 mJ/m², de préférence égale ou inférieure à 13 mJ/m², mieux égale ou inférieure à 12 mJ/m². L'énergie de surface est calculée selon la méthode Owens-Wendt décrite dans la référence: « Estimation of the surface force energy of polymers » Owens D. K., Wendt R. G. (1969), J. Appl. Polym. Sci., 13, 1741-1747. Les liquides utilisés sont l'eau et le diiodométhane.

Des composés utilisables pour obtenir de tels revêtements sont décrits dans les brevets JP2005187936 et US6183872. Des compositions commerciales permettant de préparer des revêtements hydrophobes et/ou oléophobes sont la composition KY130® de la société Shin-Etsu Chemical ou la composition OPTOOL DSX®, commercialisée par la société Daikin Industries.

Préférentiellement, un article selon l'invention comprend un substrat successivement revêtu d'une couche de primaire d'adhésion et/ou antichoc, d'un revêtement anti-abrasion et/ou anti-rayure, d'un revêtement interférentiel optionnellement antistatique comprenant une couche L selon l'invention, et d'un revêtement hydrophobe et/ou oléophobe.

L'invention est illustrée, de façon non limitative, par les exemples suivants. Sauf indication contraire, les indices de réfraction sont donnés pour une longueur d'onde de 632,8 nm et T = 20-25°C.

### EXEMPLES

### 1. Procédures générales

Les articles employés dans les exemples comprennent un substrat de lentille ORMA® ESSILOR de 65 mm de diamètre, de puissance -2,00 dioptries et d'épaisseur 1,2 mm, revêtu sur sa face concave du revêtement de primaire antichoc et du revêtement anti-abrasion et anti-rayures (hard coat) divulgués dans la partie expérimentale de la demande WO-2010/109154, et une couche L selon l'invention.

Dans l'exemple 4 et l'exemple comparatif n°2, les articles précédents sont en outre revêtus d'un revêtement antireflet comprenant, dans l'ordre, à partir du revêtement anti-abrasion et anti-rayures, une couche de ZrO₂ (30 nm), une couche de SiO₂ (30 nm), une couche de ZrO₂ (70 nm) et une couche ITO (5 nm), la couche L ou une couche de MgF₂ étant directement déposée sur la couche ITO, une couche mince organique-inorganique étant éventuellement déposée sur la couche L.

Le bâti de dépôt sous vide est une machine Leybold LH1100+, équipée d'un canon à électrons pour l'évaporation des matériaux précurseurs, d'un évaporateur thermique, d'un canon à ions KRI EH 1000 F (de la société Kaufman & Robinson Inc.) pour la phase préliminaire de préparation éventuelle de la surface du substrat par des ions argon (IPC), ainsi que pour le dépôt de la couche L sous bombardement ionique (IAD), et d'un système d'introduction de vapeur, utilisé lorsque le composé précurseur de la couche L est un liquide dans les conditions normales de température et de pression (cas de DMTS). Ce système comprend un réservoir contenant le composé précurseur liquide de la couche L, des résistances pour chauffer le réservoir et les tubes reliant le réservoir de précurseur liquide à la machine de dépôt sous vide, un débitmètre pour la vapeur de la société MKS (MKS1150C).

La vapeur de DMTS sort d'un tuyau en cuivre à l'intérieur de la machine, à une distance d'environ 30 cm du canon à ions. Des débits d'oxygène et/ou d'argon et/ou d'azote sont introduits à l'intérieur du canon à ions.

Les couches L selon l'invention sont formées par évaporation sous vide assistée par faisceau d'ions pendant le dépôt (source d'évaporation : canon à électrons) de décaméthyltétrasiloxane, fourni par la société Sigma-Aldrich et d'un fluorure de magnésium.

La couche mince organique-inorganique éventuelle est également formée par évaporation sous vide assistée par faisceau d'ions pendant le dépôt de décaméthyltétrasiloxane.

Sauf indication contraire, les épaisseurs mentionnées sont des épaisseurs physiques. Plusieurs échantillons de chaque verre ont été préparés.

### 2. Modes opératoires

Le procédé de préparation des articles d'optique revêtus d'une couche L selon l'invention comprend l'introduction du substrat revêtu du revêtement de primaire, du revêtement anti-abrasion (substrat n°1 et éventuellement du revêtement antireflet (substrat n°2) définis ci-dessus dans l'enceinte de dépôt sous vide, le préchauffage du réservoir, des tuyaux et du débitmètre à vapeur à la température choisie (∼ 15 min), une étape de pompage primaire, puis de pompage secondaire pendant 400 s permettant l'obtention d'un vide secondaire (∼2. 10⁻⁵ mbar, pression lue sur une jauge Bayard-Alpert), une étape éventuelle d'activation de la surface du substrat par un faisceau d'ions argon (IPC : 1 minute, 100 V, 1 A, le canon à ions restant en fonctionnement à la fin de cette étape), puis le dépôt par évaporation de la couche L, réalisé de la façon suivante.

Le canon à ions ayant été démarré avec de l'argon, de l'oxygène et/ou de l'azote est ajouté dans le canon à ions avec un débit programmé, le courant d'anode souhaité est programmé (2-3 A) et le débit d'argon est éventuellement arrêté, selon les conditions de dépôt souhaitées.

Le fluorure de magnésium est préchauffé de manière à se trouver dans un état fondu puis évaporé à l'aide d'un canon à électrons, l'obturateur du canon à ions et celui du canon à électrons étant ouverts simultanément. Dans le même temps, le composé DMTS est introduit dans l'enceinte sous forme gazeuse, à un débit ou une pression partielle contrôlé(e).

Une mince couche organique-inorganique est déposée dans des conditions analogues, mais en l'absence de co-évaporation de MgF₂.

L'épaisseur des couches déposées a été contrôlée en temps réel au moyen d'une microbalance à quartz, en modifiant si besoin la vitesse de dépôt en ajustant le courant du canon à électrons. Une fois l'épaisseur souhaitée obtenue, les deux obturateurs sont fermés, les canons à ions et électrons arrêtés, et les débits de gaz (oxygène, azote, éventuellement argon et vapeurs de DMTS) sont arrêtés.

Enfin, une étape de ventilation est réalisée.

Les paramètres précis du procédé de formation de la couche L et de la mince couche organique-inorganique (exemples selon l'invention) et de la seule couche de MgF₂ (exemples comparatifs) sont donnés dans le tableau I ci-dessous).

**Tableau I**

| Exemple | Substrat | Couche déposée | | | Assistance ionique | | | | Débit DMTS* (sccm) |
|---|---|---|---|---|---|---|---|---|---|
| | | Nature de la couche | Epaisseur (nm) | Vitesse de dépôt (nm/s) | Intensité de courant (A) | Débit gaz (sccm) | | | |
| | | | | | | O₂ | Ar | N₂ | |
| 1 | n°1 | L | 300 | 2 | 3 | 20 | 0 | 0 | 20 |
| 2 | n°1 | L | 300 | 2 | 2 | 0 | 0 | 20 | 20 |
| 3 | n°1 | L | 300 | 2 | 3 | 0 | 20 | 20 | 20 |
| 4 | n°2 | L | 80 | 2 | 3 | 20 | 0 | 0 | 20 |
| | | couche organique-inorganique | 5 | 2 | 3 | 20 | 0 | 0 | 20 |
| C1 | n°1 | MgF₂ | 300 | 2 | 3 | 20 | 10 | 0 | - |
| C2 | n°2 | MgF₂ | 80 | 2 | 3 | 20 | 0 | 0 | - |

| | | | | | | | | | |
|---|---|---|---|---|---|---|---|---|---|
| * décaméthyltétrasiloxane | | | | | | | | | |

### 3. Caractérisations

### - Température critique

La température critique de l'article est mesurée 24 heures ou une semaine après sa préparation, de la façon suivante :
La lentille organique ophtalmique revêtu est placé pendant 1 heure dans une étuve thermostatée à une température T de 50°C, retiré del'étuve puis l'aspect visuel de l'article est évalué en réflexion sous une lampe de bureau. Si le revêtement apparaît intact, la lentille organique ophtalmique est replacée dans l'étuve pendant 1 heure à la température T + 10°C. Dès que le revêtement apparaît craquelé, le test est arrêté. La température critique correspond à la température d'apparition des craquelures.

### - Indice de réfraction

Les mesures d'indice de réfraction ont été réalisées à la longueur d'onde de 632,8 nm, sauf indication contraire, par ellipsométrie. Plus précisément, l'indice de réfraction est obtenu par une mesure ellipsométrique en utilisant un ellipsomètre (RC2, J. A. Woollam) équipé d'un double compensateur rotatif. L'indice de réfraction est déduit de la relation de dispersion qui modélise la réponse optique fournie par les angles ellipsométriques Ψ et Δ. Pour des matériaux diélectriques tels que MgF₂, l'équation de Tauc-Lorentz, connue de l'homme du métier) modélise bien les propriétés optiques des couches déposées. Toutes les mesures ont été effectuées à des angles d'incidence de 45°, 55°, 65° et 75° dans une gamme de longueurs d'onde de 190-1700 nm.

Les propriétés d'adhésion de l'ensemble du revêtement interférentiel au substrat ont été vérifiées sur la face convexe de la lentille au moyen du test appelé "n×10 coups", en suivant la procédure décrite dans les demandes internationales WO 2010/109154 et WO 99/49097. L'appréciation consiste à relever le nombre de sollicitations que peut supporter une lentille avant l'apparition d'un défaut. Par conséquent, plus la valeur obtenue au test n×10 coups est élevée, meilleure est l'adhésion du revêtement interférentiel au substrat.

La résistance à l'abrasion de l'article a été évaluée par détermination des valeurs BAYER ASTM (Bayer sable) sur les substrats revêtus du revêtement antireflet selon les méthodes décrites dans la demande WO 2008/001011 (norme ASTM F 735.81). Plus la valeur obtenue au test BAYER est élevée, plus la résistance à l'abrasion est élevée. Ainsi, la valeur de Bayer ASTM (Bayer sable) est qualifiée de bonne lorsqu'elle est supérieure ou égale à 3,4 et inférieure à 4,5 et d'excellente pour des valeurs de 4,5 et plus.

### 4. Résultats

Le tableau II ci-dessous présente les performances optiques et mécaniques de différents articles selon l'invention ou comparatifs ainsi que les conditions de dépôt des différentes couches.

**Tableau II**

| Exemples | Indice de réfraction à 632,8 nm | Température critique (°C) | | Bayer sable | Test N10-Coups Cc/Cx |
|---|---|---|---|---|---|
| | | T +24h | T +1semaine | | |
| 1 | 1,41-1,42 | - | 120 | - | - |
| 2 | 1,39-1,41 | - | 110-120 | - | - |
| 3 | 1,37-1,40 | - | 120 | - | - |
| 4 | - | 70 | - | 5,5-6,7 | 13/13 |
| C1 | 1,37-1,38 | - | 50 | - | - |
| C2 | - | 50 | - | 7,0 | 13/13 |

Les articles selon l'invention présentent une température critique nettement améliorée par rapport à une couche exclusivement composée de MgF₂. En outre, ils présentent une résistance à l'abrasion (Exemple 4) ainsi que des propriétés de résistance mécanique (Bayer) proches d'une couche de MgF₂.

L'indice de réfraction des couches hybrides selon l'invention a une valeur très proche de celle d'une couche bas indice uniquement composée de MgF₂.

## Revendications

1. Article comprenant un substrat ayant au moins une surface principale revêtue d'au moins une couche L d'un matériau M obtenu par dépôt sous vide, par co-évaporation, d'au moins un composé métallique A choisi parmi les fluorures des métaux alcalino-terreux et d'au moins un composé organique B, le matériau M ayant un indice de réfraction à la longueur d'onde de 632,8 nm allant de 1,38 à 1,47, **caractérisé en ce que** :
- le composé organique B comprend un composé organosilicié ou un mélange de composés organo-siliciés ; et
- le dépôt du composé B, sous forme gazeuse, est effectué en présence d'un bombardement ionique.

2. Article selon la revendication 1, **caractérisé en ce que** le composé organique B ne comporte aucun hydrocarbure fluoré.

3. Article selon la revendication 1 ou 2, **caractérisé en ce que** le bombardement ionique est réalisé au moyen d'un canon à ions.

4. Article selon l'une des revendications 1 à 3, **caractérisé en ce que** le dépôt du composé organosilicié B sous bombardement ionique s'effectue en présence d'un gaz choisi parmi l'oxygène, les gaz rares, l'azote et un mélange de deux ou plus de ces gaz.

5. Article selon l'une des revendications 1 à 4, **caractérisé en ce que** l'évaporation du composé métallique A s'effectue au moyen d'un canon à électrons.

6. Article selon l'une quelconque des revendications 1 à 5, **caractérisé en ce que** le composé métallique A est MgF₂.

7. Article selon l'une quelconque des revendications 1 à 6, **caractérisé en ce que** le composé organosilicié B comporte au moins une liaison Si-C.

8. Article selon l'une des revendications des revendications précédentes, **caractérisé en ce que** le composé organosilicié B comporte au moins un groupe divalent de formule : 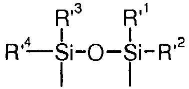 où R'¹ à R'⁴ désignent indépendamment des groupes alkyle, vinyle, aryle, hydroxyle ou des groupes hydrolysables, ou **en ce que** le composé B répond à la formule : 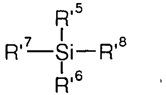 dans laquelle R'5, R'6, R'7, R'8 désignent indépendamment des groupes hydroxyle ou des groupes hydrolysables tels que des groupes OR, dans lesquels R est un groupe alkyle.

9. Article selon l'une quelconque des revendications précédentes, **caractérisé en ce que** le composé B est choisi parmi l'octaméthylcyclotétrasiloxane, le 2,4,6,8-tétraméthylcyclotétrasiloxane, le décaméthyltétrasiloxane, le décaméthylcyclopentasiloxane, le dodécaméthylpentasiloxane, l'hexaméthyldisiloxane.

10. Article selon l'une quelconque des revendications précédentes, **caractérisé en ce que** le ou les atomes de silicium du composé organosilicié B ne comportent aucun groupe hydrolysable ou groupe hydroxyle.

11. Article selon l'une quelconque des revendications précédentes, **caractérisé en ce que** la couche L constitue au moins une couche d'un revêtement interférentiel multicouche.

12. Article selon la revendication 11, **caractérisé en ce que** la couche L constitue la couche du revêtement interférentiel la plus éloignée du substrat et qu'une mince couche organique-inorganique est déposée sur ladite couche L, ladite couche organique-inorganique d'épaisseur 1 à 20 nm ayant été obtenue par dépôt d'un composé organosilicié ou un mélange de composés organo-siliciés sous forme gazeuse, en présence d'un bombardement ionique et en l'absence d'un précurseur minéral.

13. Article selon la revendication 11 ou 12, **caractérisé en ce que** le revêtement interférentiel est un revêtement antireflet.

14. Article selon l'une quelconque des revendications précédentes, **caractérisé en ce qu'**il est une lentille optique, de préférence une lentille ophtalmique.

15. Article selon l'une quelconque des revendications précédentes, **caractérisé en ce qu'**il possède une température critique supérieure ou égale à 70°C.

16. Procédé de fabrication d'un article selon l'une quelconque des revendications précédentes, comprenant au moins les étapes suivantes :
- fournir un article comprenant un substrat ayant au moins une surface principale,
- déposer sur ladite surface principale du substrat une couche L d'un matériau M ayant un indice de réfraction allant de 1,38 à 1,47 à la longueur d'onde de 632,8 nm
- récupérer un article comprenant un substrat ayant une surface principale revêtue d'une couche L,
ladite couche L ayant été obtenue par dépôt, par co-évaporation, d'au moins un un composé métallique A choisi parmi les fluorures des métaux alcalino-terreux et d'au moins un composé B organosilicié, le dépôt du composé B organosilicié, sous forme gazeuse, étant effectué en présence d'un bombardement ionique.

## Patentansprüche

1. Gegenstand, der ein Substrat umfasst, welches mindestens eine Hauptoberfläche aufweist, die mit mindestens einer Schicht L aus einem Material M überzogen ist, welches durch Vakuumabscheidung erhalten wurde, indem mindestens eine Metallverbindung A, die aus den Fluoriden von Erdalkalimetallen ausgewählt ist, und mindestens eine organischen Verbindung B gemeinsam verdampft wurden, wobei das Material M bei der Wellenlänge 632,8 nm einen Brechungsindex im Bereich von 1,38 bis 1,47 hat, **dadurch gekennzeichnet, dass**
- die organische Verbindung B eine Organosiliciumverbindung oder eine Mischung von Organosiliciumverbindungen umfasst; und
- das Abscheiden der Verbindung B, in gasförmiger Phase, unter Ionenbeschuss durchgeführt wird.

2. Gegenstand nach Anspruch 1, **dadurch gekennzeichnet, dass** die organische Verbindung B keinerlei fluorierten Kohlenwasserstoff aufweist.

3. Gegenstand nach Anspruch 1 oder 2, **dadurch gekennzeichnet, dass** der Ionenbeschuss mittels einer Ionenkanone durchgeführt wird.

4. Gegenstand nach einem der Ansprüche 1 bis 3, **dadurch gekennzeichnet, dass** das Abscheiden der Organosiliciumverbindung B unter Ionenbeschuss in Gegenwart eines Gases erfolgt, welches aus Sauerstoff, den Edelgasen, Stickstoff und einer Mischung aus mindestens zweien dieser Gase ausgewählt ist.

5. Gegenstand nach einem der Ansprüche 1 bis 4, **dadurch gekennzeichnet, dass** das Verdampfen der Metallverbindung A mittels einer Elektronenkanone erfolgt.

6. Verfahren nach einem beliebigen der Ansprüche 1 bis 5, **dadurch gekennzeichnet, dass** es sich bei der Metallverbindung A um MgF₂ handelt.

7. Gegenstand nach einem beliebigen der Ansprüche 1 bis 6, **dadurch gekennzeichnet, dass** die Organosiliciumverbindung B mindestens eine Si-C-Verbindung aufweist.

8. Gegenstand nach einem der Ansprüche der vorhergehenden Ansprüche, **dadurch gekennzeichnet, dass** die Organosiliciumverbindung B mindestens eine zweibindige Gruppe der folgenden Formel aufweist: 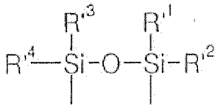 wobei R'¹ bis R'⁴ unabhängig voneinander für Alkyl-, Vinyl-, Aryl-, Hydroxylgruppen oder für hydrolysierbare Gruppen stehen, oder dadurch, dass die Verbindung B der folgenden Formel entspricht: 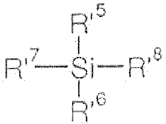 in welcher R'5, R'6, R'7, R'8 unabhängig voneinander für Hydroxylgruppen oder für hydrolysierbare Gruppen wie etwa OR-Gruppen stehen, in welchen R eine Alkylgruppe ist.

9. Gegenstand nach einem beliebigen der vorhergehenden Ansprüche, **dadurch gekennzeichnet, dass** die Verbindung B aus Octamethylcyclotetrasiloxan, 2,4,6,8-Tetramethylcyclotetrasiloxan, Decamethyltetrasiloxan, Decamethylcyclopentasiloxan, Dodecamethylpentasiloxan, Hexamethyldisiloxan ausgewählt ist.

10. Gegenstand nach einem beliebigen der vorhergehenden Ansprüche, **dadurch gekennzeichnet, dass** das oder die Siliciumatome der Organosiliciumverbindung B keinerlei hydrolysierbare Gruppe oder Hydroxylgruppe aufweisen.

11. Gegenstand nach einem beliebigen der vorhergehenden Ansprüche, **dadurch gekennzeichnet, dass** die Schicht L mindestens eine Schicht einer mehrschichtigen Interferenzbeschichtung darstellt.

12. Gegenstand nach Anspruch 11, **dadurch gekennzeichnet, dass** die Schicht L diejenige Schicht der Interferenzbeschichtung darstellt, welche am weitesten vom Substrat entfernt ist, und dass eine organisch-anorganische Dünnschicht auf der Schicht L abgeschieden wird, wobei die organisch-anorganische Schicht mit einer Dicke von 1 bis 20 nm durch Abscheiden einer Organosiliciumverbindung oder einer Mischung von Organosiliciumverbindungen in gasförmiger Phase unter Ionenbeschuss und in Abwesenheit einer mineralisch Vorläufersubstanz erhalten wurde.

13. Gegenstand nach Anspruch 11 oder 12, **dadurch gekennzeichnet, dass** es sich bei der Interferenzbeschichtung um eine Antireflexbeschichtung handelt.

14. Gegenstand nach einem beliebigen der vorhergehenden Ansprüche, **dadurch gekennzeichnet, dass** es sich um eine optische Linse, vorzugsweise eine augenmedizinische Linse, handelt.

15. Artikel nach einem beliebigen der vorhergehenden Ansprüche, **dadurch gekennzeichnet, dass** er eine kritische Temperatur von mindestens 70 °C besitzt.

16. Verfahren zur Herstellung eines Gegenstands nach einem beliebigen der vorhergehenden Ansprüche, wobei es mindestens die folgenden Schritte umfasst:
- Bereitstellen eines Gegenstands, der ein Substrat umfasst, welches mindestens eine Hauptoberfläche aufweist,
- Abscheiden einer Schicht L aus einem Material M, das bei der Wellenlänge von 632,8 nm einen Brechungsindex im Bereich von 1,38 bis 1,47 hat, auf der Hauptoberfläche des Substrats,
- Entnehmen eines Gegenstands, der ein Substrat umfasst, welches eine Hauptoberfläche aufweist, die mit einer Schicht L überzogen ist,
wobei die Schicht L durch Abscheidung erhalten wurde, indem mindestens eine Metallverbindung A, die aus den Fluoriden von Erdalkalimetallen ausgewählt ist, und mindestens eine Organosiliciumverbindung B gemeinsam verdampft wurden, wobei das Abscheiden der Organosiliciumverbindung B, in gasförmiger Phase, unter Ionenbeschuss erfolgt.

## Claims

1. Article comprising a substrate having at least one main surface coated with at least one layer L of a material M obtained by vacuum deposition, by co-evaporation, of at lease one metallic compound A chosen from alkaline-earth metal fluorides and of at least one organic compound B, the material M having a refractive index at the wavelength of 632.8 nm ranging from 1.38 to 1.47, **characterized in that**:
- the organic compound B comprises an organosilicon compound or a mixture of organosilicon compounds; and
- the deposition of the compound B, in gaseous form, is carried out in the presence of an ion bombardment.

2. Article according to Claim 1, **characterized in that** the organic compound 13 does not comprise any fluorocarbon.

3. Article according to Claim 1 or 2, **characterized in that** the ion bombardment is carried out using an ion gun.

4. Article according to one of Claims 1 to 3, **characterized in that** the deposition of the organosilicon compound B under ion bombardment is carried out in the presence of a gas chosen from oxygen, noble gases, nitrogen and a mixture of two or more of these gases.

5. Article according to one of Claims 1 to 4, **characterized in that** the evaporation of the metallic compound A is carried out using an electron gun.

6. Article according to any one of Claims 1 to 5, **characterized in that** the metallic compound A is MgF₂.

7. Article according to any one of Claims 1 to 6, **characterized in that** the organosilicon compound B comprises at least one Si-C bond.

8. Article according to one of the claims of the preceding claims, **characterized in that** the organosilicon compound B comprises at least one divalent group of formula: 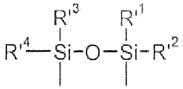 where R'¹ to R'⁴ independently denote alkyl, vinyl, aryl or hydroxyl groups or hydrolysable groups, or **in that** the compound B corresponds to the formula: 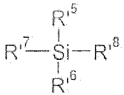 in which R'⁵, R'⁶, R'⁷ and R'⁸ independently denote hydroxyl groups or hydrolysable groups, such as OR groups, in which R is an alkyl group.

9. Article according to any one of the preceding claims, **characterized in that** the compound B is chosen from octamethylcyclotetrasiloxane, 2,4,6,8-tetramethylcyclotetrasiloxane, decamethyltetrasiloxane, decamethylcyclopentasiloxane, dodecamethylpentasiloxane or hexamethyldisiloxane.

10. Article according to any one of the preceding claims, **characterized in that** the silicon atom or atoms of the organosilicon compound B do not comprise any hydrolysable group or hydroxyl group.

11. Article according to any one of the preceding claims, **characterized in that** the layer L constitutes at least one layer of a multilayer interference coating.

12. Article according to Claim 11, **characterized in that** the layer L constitutes the layer of the interference coating furthest from the substrate and that a thin organic-inorganic layer is deposited on said layer L, said organic-inorganic layer with a thickness of 1 to 20 nm having been obtained by deposition of an organosilicon compound or a mixture of organosilicon compounds in gaseous form, in the presence of an ion bombardment and in the absence of a mineral precursor.

13. Article according to Claim 11 or 12, **characterized in that** the interference coating is an antireflective coating.

14. Article according to any one of the preceding claims, **characterized in that** it is an optical lens, preferably an ophthalmic lens.

15. Article according to any one of the preceding claims, **characterized in that** it possesses a critical temperature greater than or equal to 70°C.

16. Process for the manufacture of an article according to any one of the preceding claims, comprising at least the following stages:
- supplying an article comprising a substrate having at least one main surface,
- depositing, on said main surface of the substrate, a layer L of a material M having a refractive index ranging from 1.38 to 1.47 at the wavelength of 632.8 nm,
- recovering an article comprising a substrate having a main surface coated with a layer L,
said layer L having been obtained by deposition, by co-evaporation, of at least one metallic compound A chosen from alkaline-earth metal fluorides and of at least one organosilicon compound B, the deposition of the organosilicon compound B, in gaseous form, being carried out in the presence of an ion bombardment.
